# EUROPEAN PATENT SPECIFICATION

(11) **EP 2 809 613 B1**
(45) Date of publication and mention of the grant of the patent: **23.12.2015**
(21) Application number: 13701708.3
(22) Date of filing: 29.01.2013
(51) Int. Cl.: C01B 31/00, C04B 35/52, C04B 35/628, C23C 16/02, B82Y 30/00, C23C 16/27

(54) **METHOD FOR THE MANUFACTURE OF COMPOSITES CONSISTING OF CARBON NANOTUBES AND CRYSTALLINE DIAMOND**
VERFAHREN ZUR HERSTELLUNG VON VERBUNDWERKSTOFFEN AUS KOHLENSTOFFNANORÖHRCHEN UND KRISTALLINDIAMANT
PROCÉDÉ DE FABRICATION DE COMPOSITES CONSTITUÉS DE NANOTUBES DE CARBONE ET DE DIAMANT CRISTALLIN

(30) Priority: 30.01.2012 US 201261592131 P
(43) Date of publication of application: 10.12.2014
(73) Proprietor: Fraunhofer Gesellschaft zur Förderung der angewandten Forschung e.V., 80686 München (DE); Commonwealth Scientific and Industrial Research Organisation, Campbell, ACT (AU)
(72) Inventor: MEIER, Sven, 79194 Gundelfingen (DE); MEE, Manuel, 79106 Freiburg (DE); SCHÜTZ, Jürg, Grovedale VIC 3216 (AU); SEARS, Kallista, Mt Waverley VIC 3149 (AU); HUYNH, Chi, Chadstone VIC 3148 (AU)
(74) Representative: Gagel, Roland
(86) International application number: PCT/EP2013/000269
(87) International publication number: WO 2013/113493

(56) References cited:
- SHANKAR ET AL: "Growth of nanodiamond/carbon-nanotube composites with hot filament chemical vapor deposition", DIAMOND AND RELATED MATERIALS, ELSEVIER SCIENCE PUBLISHERS, AMSTERDAM, NL, vol. 17, no. 1, 7 November 2007 (2007-11-07), pages 79-83, XP022382305, ISSN: 0925-9635, DOI: 10.1016/J.DIAMOND.2007.10.031 cited in the application
- ORLANDUCCI S ET AL: "Nanodiamond-coated carbon nanotubes: early stage of the CVD growth process", CHEMICAL VAPOR DEPOSITION, WILEY-VCH VERLAG, WEINHEIM, DE, vol. 14, no. 7/8, 1 July 2008 (2008-07-01) , pages 241-246, XP001514537, ISSN: 0948-1907, DOI: 10.1002/CVDE.200706656
- HASAN-AL MEHEDI ET AL: "Diamond Nanocrystals Growth on Carbon Nanotubes", AIP CONFERENCE PROCEEDINGS, vol. 1292, 1 January 2010 (2010-01-01), pages 141-144, XP055062804, ISSN: 0094-243X, DOI: 10.1063/1.3518281
- GUGLIELMOTTI V ET AL: "Carbon nanotube/nanodiamond structures: An innovative concept for stable and ready-to-start electron emitters", APPLIED PHYSICS LETTERS, AIP, AMERICAN INSTITUTE OF PHYSICS, MELVILLE, NY, US, vol. 95, no. 22, 3 December 2009 (2009-12-03), pages 222113-222113, XP012126644, ISSN: 0003-6951, DOI: 10.1063/1.3269929

## Description

The present invention relates to a method for the manufacture of composites consisting of carbon nanotubes (CNTs) and/or carbon fibres (CFs) and crystalline diamond. Such composites hold promise for a wide range of applications due to a synergy between the outstanding properties of their individual components. CNTs as well as CFs exhibit a range of extraordinary properties such as high mechanical strength, flexibility and electrical conductivity. Diamond on the other hand is well known for its exceptional physical properties such as hardness and is consequently used extensively in wear resistance coatings, as well as for cutting and polishing tools. Although diamond thin films are hard, they often suffer from mechanical failure due to brittleness. Composites of CNTs/CFs and diamond are highly desirable as they could enable the manufacture of materials with excellent mechanical, electrical and thermal properties. Of particular interest are diamond coated yarns of CNTs / CFs with high tensile strength for separating semiconducting materials. So far, a slurry process or diamond-studded steel wires are used which suffer from significant shortcomings and deficiencies. In contrast to this, diamond coated yarns of CNTs/CFs enable the possibility for improvement in efficiency and cost savings.

However, achieving a controlled combination of structures that consist of these materials is still a challenge due to the extreme conditions involved in the synthesis of diamond that lead to degradation of CNTs/CFs. Diamond coatings are typically deposited by chemical vapor deposition (CVD) in a strong hydrogen-enriched plasma at temperatures above 700°C. The hydrogen acts as a catalyst by promoting the formation of sp³-bonded carbon while breaking sp²-bonded carbon. However this is not conducive to CNT growth or preservation as the atomic hydrogen degenerates the sp²-bonded CNTs/CFs as well. CNTs only survive within a narrow parameter window that is less than optimal for diamond growth. Therefore new and more flexible approaches are needed which allow CNTs/CFs and diamond to be combined into various composite structures without sacrificing the quality of either component.

Previous attempts made to create composite CNT/diamond structures have relied on adjusting the process parameters during diamond synthesis to either depositing both CNTs and diamond simultaneously or sequentially, i.e. first the CNTs and then the diamond. The two approaches described in the following are known to lead to true CNT/diamond composites where there is direct contact between diamond and CNTs surfaces.

M. Terranova et al., Chemistry of Materials 17 (2005) 3214, have grown both CNTs and nanocrystalline diamond in a one step process by streaming carbon nanoparticles in Argon over an iron catalyst coated Silicon substrate inside a hot filament chemical vapor deposition (HFCVD) setup. This resulted in the growth of nanocrystalline diamond particles on bundles of single-wall CNTs. N. Shankar et al., "Growth of nanodiamond/carbon-nanotube composite with hot filament chemical vapor deposition", Diamond Related Matter, 17 (2008), pp. 79 - 83., have grown diamond/CNT composites by first dispersing multi-walled CNTs onto a Si substrate and then using hot filament chemical vapor deposition (HFCVD) to deposit diamond onto this structure. They found that at 1% CH₄ in H₂, typical conditions for diamond growth, the CNTs were destroyed. However by increasing the flow of CH₄ in H₂ to between 2% and 5%, i.e. reducing the etching effect due to H₂ partial pressure, they found that diamond nucleates and grows on the CNTs without etching them away. However, the reduced etching activity had a negative effect on the morphology of the diamond particles, which changed from a microcrystalline structure to a "cauliflower" morphology with numerous nano-sized (100-400 nm) diamond particles randomly nucleating and growing on the CNTs.

The two approaches discussed have the disadvantage that the quality of the CNTs, the diamond or both is compromised. In both works, those by Terranova et al. and by Shankar et al., the diamond formed consists exclusively of crystallite made up of very small nano-crystals and no microcrystalline diamond is formed. Secondly, the composite formation process works only within a narrow parameter window that allows little flexibility for varying the type or structure of composites formed.

It is thus an object of the present invention to provide a method for the manufacture of composites of carbon nanotubes and/or carbon fibres with crystalline diamond where the diamond crystals formed are of high quality and which are firmly attached on the surfaces of carbon nanotubes or fibres or on structures formed of the two without damaging the CNTs and CFs.

The objective is achieved by the method according to claim 1. Advantageous embodiments of the proposed method are subject matter of the dependent claims or are described in the subsequent portions of the description and embodiments.

In the proposed method of manufacturing composites from carbon nanotubes and/or carbon fibres and crystalline diamond, performing the following process steps is essential:
- In a first step, the carbon nanotubes, the carbon fibres or structures formed of the two are coated with a barrier layer. The barrier material is selected in such a way that the barrier layer protects the carbon nanotubes, carbon fibres or CNT/CF structures against the reactive gases and temperatures required to form the high quality crystalline diamond. The structures formed of carbon nanotubes may be any arrangement of such nanotubes, including CNT forests, spin coated films of dispersed CNTs on various substrates, CNT webs or CNT yarns.
- In a second step, the barrier layer on the carbon nanotubes, carbon fibres or CNT/CF composites is equipped with a high density of nucleation sites on the barrier layer. It is preferred that an ultrasonic bath with a suspension of nanocrystalline diamond is used to form the nucleation sites. Nucleation sites may also be created by bias enhanced nucleation (BEN) or other techniques.
- In the subsequent third step crystalline diamond is deposited or synthesized on the barrier layer of the carbon nanotubes, carbon fibres or CNT/CF composite using a chemical vapor deposition (CVD) process in a reactive gas atmosphere that promotes the formation of sp³-bonded carbon. In contrast to the two approaches discussed before the growth process is guided predominantly by grain growth of the initial nucleation sites without significant secondary nucleation taking place. The result is a structure with enclosed CNTs/CFs by diamond grains.

According to the proposed method, a very thin barrier coating is deposited on the CNTs/CFs or on the corresponding CNT/CF structure of interest prior to diamond deposition. This barrier layer is used for protecting the CNTs/CFs from the harsh conditions needed to deposit high quality diamond. The advantage obtained from this measure is that there is no need to accept a compromise for the diamond or CNT growth parameters. The process conditions for depositing crystalline diamond can thus be freely selected to achieve high quality crystalline diamond without considering a possible damage of the CNTs/CFs by the required reactive gas atmosphere. The barrier layer may also support diamond nucleation and/or act as an adhesion-promoting agent allowing greater load transfer between the diamond and the CNTs/CFs. A very important benefit of the barrier layer is a greater flexibility in the range of composite structures that can be manufactured with the proposed method. Diamond coatings can be applied to various CNT/CF structures such as aligned forests of CNTs, CNT Bucky-papers (random networks of CNTs), CNT webs and CNT yarns. It also offers the flexibility of adjusting the volume fraction of the CNTs/CFs in the composite, the prospect of developing layered composites, and the ease of scale-up for use as thin, hard and tough wear-resistant coatings. Particularly worthwhile mentioning is the use of diamond-coated CNT or CF yarns as an alternative to conventional saw wires for cutting silicon wafers.

The barrier material can be selected from a number of different materials which provide the required protective properties, which is to protect the CNTs against the reactive gases used for the deposition and formation of high quality crystalline diamond. This high quality crystalline diamond of the present patent application is characterized by the fact that grain growth is promoted only at initial nucleation sites and no secondary nucleation of diamond occurs. To achieve this, by way of example, a strong hydrogen enriched plasma in a reactive gas atmosphere that contains more than 98% Hydrogen is used.

An example of such a barrier layer having the desired properties is a thin, few nanometers thick, amorphous SiOC:H layer, which is deposited by a capacitive coupled PECVD process. Tetramethylsilane (TMS) and Oxygen are used as precursors. A further example is a layer of amorphous SiₓO_{y} (e.g. SiO₂) or SiC.

The barrier layer is coated on the CNTs/CFs or on the structure formed of the CNTs/CFs with a minimum thickness required to achieve the desired protective function.

Typically this barrier layer has a thickness of less than 100 nanometres.

It is preferred that the barrier layer thickness is less than 20 nanometers, more preferred less than 10 nanometers or even more preferred only a few nanometres.

The coating of the carbon nanotubes/carbon fibres or of the structure of carbon nanotubes/carbon fibres is performed preferably using plasma enhanced chemical vapor deposition (PECVD). Nevertheless, also other coating techniques may be used to prepare the CNTs/CFs for the subsequent diamond deposition step. The PECVD process may be performed at low pressure and moderate temperatures to avoid a damage of the CNTs/CFs by the coating step.

The step of depositing crystalline diamond on the carbon nanotubes/carbon fibres or on the structure of carbon nanotubes/carbon fibres carrying the barrier layer is preferably performed using microwave-based chemical vapor deposition method. The reactive gas atmosphere used for the deposition of high quality diamond may consist of any gas composition favorable for the deposition of diamond that does not support secondary nucleation. In one embodiment the reactive gas atmosphere contains more than 98% H₂ and less than 2% CH₄. The temperatures and pressures during the process are selected to achieve a high quality crystalline diamond layer on the carbon nanotubes/ carbon fibres or on the structure of the carbon nanotubes/carbon fibres. Typically the pressure is below 100 hPa and the temperature is above 700°C.

In a preferred embodiment the step of coating the CNTs/CFs or the structure of CNTs/CFs with the barrier layer is performed by a capacitively coupled PECVD process and the subsequent synthesis of diamond in a microwave ring-resonator based apparatus known as Cyrannus^{®}.

The proposed method is described in the following by way of examples in connection with the accompanying drawings in further detail. The figures show:
- Figure 1: a flow chart of the method steps of the proposed method; and
- Figure 2: a schematic view of the formation steps involved in manufacturing the proposed composite according to the proposed method, at the example of a CNT forest.

In an example of the proposed method a high quality diamond layer is formed on a CNT structure which is protected against damage by a thin amorphous SiOC:H layer of only few nanometers thickness.

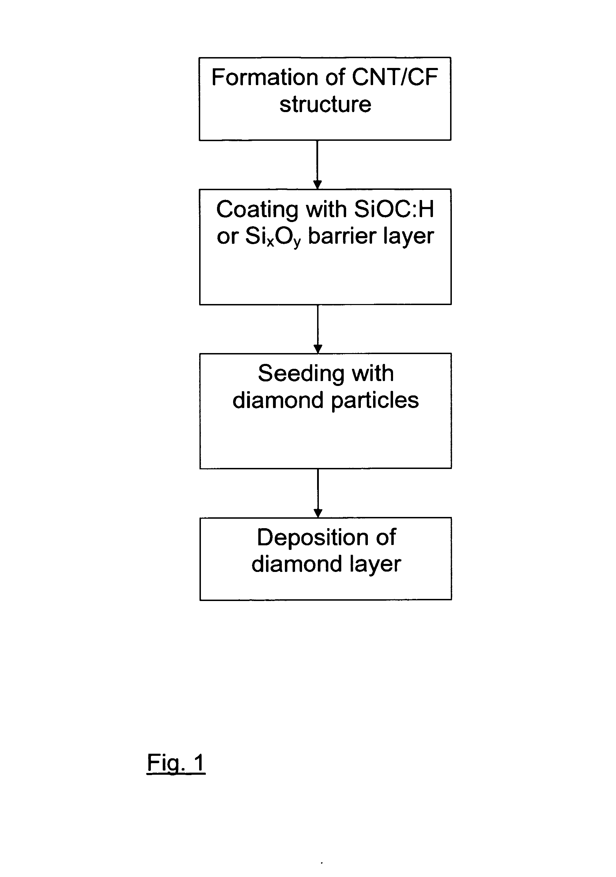

The exemplary process is schematically depicted in Fig. 1 and can be broken down into four steps:
1. Form the CNT/CF structure of interest, e.g. a CNT forest or CNT yarn.
2. Coat the CNT/CF structure with a SiOC:H layer based on Tetramethylsilane (TMS) and Oxygen (O₂) by using a capacitively coupled PEVD process at low pressure and moderate temperature.
3. Seed the SiOC:H coated CNT/CF structure in an ultrasonic bath using a suspension of nanocrystalline diamond powder in ethanol or by using bias enhanced nucleation (BEN).
4. Diamond synthesis by a microwave-based CVD process using a proprietrary Cyrannus^{®} reactor under standard conditions (more than 98% H₂ and less than 2% CH₄ at a pressure of 70 hPa and a temperature of 850°C).

The first step of forming the structure of interest is not necessarily part of the proposed method. This structure of interest can be sourced elsewhere for the proposed method.

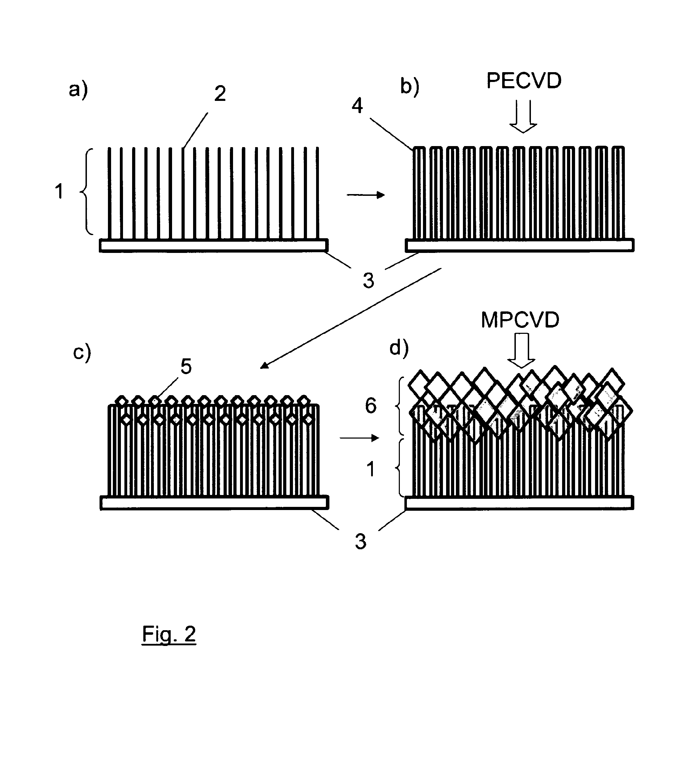

Figure 2 shows an application of the proposed method for creating a crystalline diamond layer on a CNT forest as the structure of interest. In figure 2a the CNT forest 1 of single carbon nanotubes 2 is provided on an appropriate substrate 3. The fabrication of such a CNT forest is not part of the present invention and already known to the skilled person.

In a first step of the proposed method as shown in figure 2b the CNTs/CFs 2 are coated in a PECVD process with a thin a-SiOC:H barrier layer 4 protecting the nanotubes against the reactive gases in the subsequent diamond deposition step. The coated structure is subsequently seeded in an ultrasonic bath by means of a suspension of ethanol or acetylene and nanocrystalline diamond particles 5 on top as schematically indicated in figure 2c or by using bias enhanced nucleation (BEN). In the last step, the diamond synthesis is performed by microwave plasma chemical vapor deposition (MPCVD) leading to a composite of the CNT forest 1 and a layer 6 of high quality crystalline diamond (figure 2d).

While the a-SiOC:H layer on the one hand helps to enable non-destructive synthesis of diamond on top of CNTs, the requirements for the use of CNTs as a conductive substrate in the shape of a nano-wire (e.g. for sensor applications) are, in addition to the ability of providing electrical insulation, first and foremost a very low dielectric constant that is conducive to avoiding the occurrence of parasitic capacitance.

In the context of these so-called "low-k dielectrics", the use of a-SiOC:H films represents already proven technology, which is suitable for the use in nanoelectronic devices, e.g. in conjunction with CNTs.

With the proposed method a large variety of composites of CNTs/CFs with crystalline diamond or structures of CNTs/CFs with crystalline diamond can be manufactured. Such composites can be used in a wide range of applications, for example:
- Carbon nanotubes/carbon fibres reinforced diamond for use as thin, hard and tough wear-resistant coatings
- Diamond coated wires consisting of diamond micro-crystals on CNT-yarns/CFs, which can be used as an alternative to common diamond-studded wires based on steel for cutting semiconducting materials like Silicon
- High temperature and pressure sensors
- Field emitters
- Micro-mechanics and sensing applications
- Flexible and bendable diamond coatings
- Nano-wires based on CNTs and CNT-yarns coated with a-SiOC:H

While the invention has been illustrated and described in detail in the drawings and in the forgoing description, such illustrations and descriptions are to be considered illustrative or exemplary and not restrictive. The invention is not limited to the disclosed embodiments. Other variations of the disclosed embodiments can be understood and effected by the skilled person in practicing the claimed invention, from a study of the drawings, the disclosure and the appended claims. In the claims, the word "comprising" does not exclude other elements or steps and the indefinite article "a" or "an" does not exclude a plurality.

### List of reference signs

- 1: CNT forest
- 2: carbon nanotubes
- 3: substrate
- 4: SiOC:H coating
- 5: nanocrystalline diamond particles
- 6: crystalline diamond layer

## Claims

1. A method for the manufacture of composites consisting of carbon nanotubes or carbon fibres or a combination of the two and crystalline diamond, said method at least comprising the steps of
- coating carbon nanotubes and/or carbon fibres or a structure formed of carbon nanotubes and/or carbon fibres with a barrier layer, a barrier material of said barrier layer being selected to protect the carbon nanotubes and/or carbon fibres against reactive gases required for diamond formation,
- equipping the barrier layer with nucleation sites for diamond,
- growing crystalline diamond on the nucleation sites of the barrier layer of the carbon nanotubes and/or carbon fibres using a chemical vapor deposition process in a reactive gas atmosphere that promotes the formation of sp³-bonded carbon.

2. The method according to claim 1,
wherein the deposition of crystalline diamond is performed based on grain growth of the initial nucleation sites while no secondary nucleation of diamond is taking place.

3. The method according to claim 1 or 2,
wherein the coating of the carbon nanotubes and/or carbon fibres with the barrier layer is performed using amorphous SiOC:H or amorphous SiₓO_{y} as said barrier material.

4. The method according to one of claims 1 to 3,
wherein the carbon nanotubes and/or carbon fibres are coated with a thickness of the barrier layer of less than 10 nm.

5. The method according to one of claims 1 to 4,
wherein the coating of the carbon nanotubes and/or carbon fibres with the barrier layer is performed using a capacitively coupled plasma for the chemical vapor deposition process.

6. The method according to one of claims 1 to 5,
wherein the step of providing nucleation sites is performed by using bias enhanced nucleation.

7. The method according to one of claims 1 to 5,
wherein the step of providing nucleation sites is performed by placing the carbon nanotubes and/or carbon fibres or the structure of carbon nanotubes and/or carbon fibres in an ultrasonic bath containing a suspension of nanocrystalline diamond powder.

8. The method according to one of claims 1 to 7,
wherein the step of depositing crystalline diamond is performed using microwave-based chemical vapor deposition.

9. The method according to one of claims 1 to 8,
wherein the step of depositing crystalline diamond is performed in a reactive gas atmosphere containing more than 98% H₂ and less than 2% CH₄.

10. The method according to one of claims 1 to 8,
wherein the step of depositing crystalline diamond is performed in a reactive gas atmosphere containing a mixture of Hydrogen, Oxygen and Methane.

11. The method according to one of claims 1 to 10,
wherein the step of depositing crystalline diamond is performed at a pressure of less than 100 hPa and at a temperature above 700°C, preferably at 850°C.

12. A composite of carbon nanotubes and/or carbon fibres and diamond, said composite comprising a barrier layer between the carbon nanotubes and/or carbon fibres or a structure formed of the carbon nanotubes and/or carbon fibres and the diamond, the barrier layer being formed of a material protecting the carbon nanotubes and/or carbon fibres against reactive gases required for diamond formation.

13. The composite according to claim 12,
wherein the barrier layer has a thickness of less than 10 nm.

14. The composite according to claim 12 or 13 forming a diamond coated carbon nanotube yarn or carbon fiber roving.

15. The composite according to claim 14 forming a sawing wire.

## Patentansprüche

1. Verfahren zur Herstellung von Verbundstoffen, bestehend aus Kohlenstoffnanoröhrchen oder Kohlenstofffasern oder einer Kombination der zwei und kristallinem Diamant, wobei das Verfahren die folgenden Schritte umfasst
- Beschichten von Kohlenstoffnanoröhrchen und/oder Kohlenstofffasern oder einer Struktur, die aus Kohlenstoffnanoröhrchen und/oder Kohlenstofffasern gebildet ist, mit einer Barriereschicht, wobei ein Barrierematerial der Barriereschicht derart ausgewählt wird, dass es die Kohlenstoffnanoröhrchen und/oder Kohlenstofffasern vor reaktiven Gasen schützt, die für die Diamantbildung erforderlich sind,
- Ausstatten der Barriereschicht mit Keimbildungsstellen für Diamant,
- Züchten von kristallinem Diamant auf den Keimbildungsstellen der Barriereschicht der Kohlenstoffnanoröhrchen und/oder Kohlenstofffasern unter Anwendung eines chemischen Gasphasenabscheidungsverfahrens in einer reaktiven Gasatmosphäre, die die Bildung von sp³-gebundenem Kohlenstoff fördert.

2. Verfahren nach Anspruch 1,
wobei die Abscheidung von kristallinem Diamant basierend auf dem Kornwachstum der anfänglichen Keimbildungsstellen, während keine sekundäre Keimbildung von Diamant stattfindet, ausgeführt wird.

3. Verfahren nach Anspruch 1 oder 2,
wobei das Beschichten der Kohlenstoffnanoröhrchen und/oder Kohlenstofffasern mit der Barriereschicht unter Verwendung von amorphem SiOC:H oder amorphem SiₓO_{y} als Barrierematerial ausgeführt wird.

4. Verfahren nach einem der Ansprüche 1 bis 3,
wobei die Kohlenstoffnanoröhrchen und/oder Kohlenstofffasern mit einer Dicke der Barriereschicht von weniger als 10 nm beschichtet werden.

5. Verfahren nach einem der Ansprüche 1 bis 4,
wobei die Beschichtung der Kohlenstoffnanoröhrchen und/oder Kohlenstofffasern mit der Barriereschicht unter Verwendung eines kapazitiv gekoppelten Plasmas für das chemische Gasphasenabscheidungsverfahren ausgeführt wird.

6. Verfahren nach einem der Ansprüche 1 bis 5,
wobei der Schritt des Bereitstellens von Keimbildungsstellen mittels bias-unterstützter Keimbildung ausgeführt wird.

7. Verfahren nach einem der Ansprüche 1 bis 5,
wobei der Schritt des Bereitstellens von Keimbildungsstellen durch Anordnen der Kohlenstoffnanoröhrchen und/oder Kohlenstofffasern oder der Struktur von Kohlenstoffnanoröhrchen und/oder Kohlenstofffasern in einem Ultraschallbad ausgeführt wird, das eine Suspension von nanokristallinem Diamantpulver enthält.

8. Verfahren nach einem der Ansprüche 1 bis 7,
wobei der Schritt des Abscheidens von kristallinem Diamant unter Anwendung einer mikrowellenbasierten chemischen Gasphasenabscheidung ausgeführt wird.

9. Verfahren nach einem der Ansprüche 1 bis 8,
wobei der Schritt des Abscheidens von kristallinem Diamant in einer reaktiven Gasatmosphäre ausgeführt wird, die mehr als 98 % H₂ und weniger als 2 % CH₄ enthält.

10. Verfahren nach einem der Ansprüche 1 bis 8,
wobei der Schritt des Abscheidens von kristallinem Diamant in einer reaktiven Gasatmosphäre ausgeführt wird, die eine Mischung von Wasserstoff, Sauerstoff und Methan enthält.

11. Verfahren nach einem der Ansprüche 1 bis 10,
wobei der Schritt des Abscheidens von kristallinem Diamant bei einem Druck von weniger als 100 hPa und bei einer Temperatur über 700 °C, vorzugsweise bei 850 °C, ausgeführt wird.

12. Verbundstoff von Kohlenstoffnanoröhrchen und/oder Kohlenstofffasern und Diamant, wobei der Verbundstoff eine Barriereschicht zwischen den Kohlenstoffnanoröhrchen und/oder Kohlenstofffasern oder einer Struktur, die aus den Kohlenstoffnanoröhrchen und/oder Kohlenstofffasern gebildet ist, und dem Diamant umfasst, wobei die Barriereschicht aus einem Material gebildet ist, das die Kohlenstoffnanoröhrchen und/oder Kohlenstofffasern vor reaktiven Gasen schützt, die zur Diamantbildung erforderlich sind.

13. Verbundstoff nach Anspruch 12,
wobei die Barriereschicht eine Dicke von weniger als 10 nm aufweist.

14. Verbundstoff nach Anspruch 12 oder 13, der ein diamantbeschichtetes Kohlenstoffnanoröhrchengarn oder Kohlenstofffaserroving bildet.

15. Verbundstoff nach Anspruch 14, der einen Sägedraht bildet.

## Revendications

1. Procédé de fabrication de composites constitués de nanotubes de carbone ou de fibres de carbone ou d'une combinaison des deux et de diamant cristallin, ledit procédé comprenant au moins les étapes consistant à :
- revêtir des nanotubes de carbone et/ou des fibres de carbone ou une structure se composant de nanotubes de carbone et/ou de fibres de carbone avec une couche barrière, un matériau barrière de ladite couche barrière étant choisi pour protéger les nanotubes de carbone et/ou les fibres de carbone des gaz réactifs nécessaires à la formation d'un diamant,
- équiper la couche barrière avec des sites de nucléation pour le diamant,
- faire croître le diamant cristallin sur les sites de nucléation de la couche barrière des nanotubes de carbone et/ou des fibres de carbone en utilisant un procédé de dépôt en phase vapeur dans une atmosphère de gaz réactifs qui favorise la formation de carbone lié sous forme sp³.

2. Procédé selon la revendication 1, dans lequel le dépôt de diamant cristallin est réalisé en fonction de la croissance des grains des sites de nucléation initiaux alors qu'aucune nucléation secondaire du diamant n'a lieu.

3. Procédé selon la revendication 1 ou 2, dans lequel le revêtement des nanotubes de carbone et/ou des fibres de carbone avec la couche barrière est réalisé en utilisant du SiOC:H amorphe ou du SiₓO_{y} amorphe en tant que ledit matériau barrière.

4. Procédé selon l'une quelconque des revendications 1 à 3, dans lequel les nanotubes de carbone et/ou les fibres de carbone sont revêtus avec une épaisseur de la couche barrière inférieure à 10 nm.

5. Procédé selon l'une quelconque des revendications 1 à 4, dans lequel le revêtement des nanotubes de carbone et/ou des fibres de carbone avec la couche barrière est réalisé en utilisant un plasma à couplage capacitif pour le procédé de dépôt chimique en phase vapeur.

6. Procédé selon l'une quelconque des revendications 1 à 5, dans lequel l'étape consistant à fournir des sites de nucléation est réalisée en utilisant une nucléation améliorée par polarisation.

7. Procédé selon l'une quelconque des revendications 1 à 5, dans lequel l'étape consistant à fournir des sites de nucléation est réalisée en plaçant les nanotubes de carbone et/ou les fibres de carbone ou la structure de nanotubes de carbone et/ou de fibres de carbone dans un bain à ultrasons contenant une suspension de poudre de diamant nanocristallin.

8. Procédé selon l'une quelconque des revendications 1 à 7, dans lequel l'étape consistant à déposer un diamant cristallin est réalisée en utilisant un déport chimique en phase vapeur basé sur un micro-onde.

9. Procédé selon l'une quelconque des revendications 1 à 8, dans lequel l'étape consistant à déposer un diamant cristallin est réalisée dans une atmosphère de gaz réactifs contenant plus de 98 % d'H₂ et moins de 2 % de CH₄.

10. Procédé selon l'une quelconque des revendications 1 à 8, dans lequel l'étape consistant à déposer un diamant cristallin est réalisée dans une atmosphère de gaz réactifs contenant un mélange d'hydrogène, d'oxygène et de méthane.

11. Procédé selon l'une quelconque des revendications 1 à 10, dans lequel l'étape consistant à déposer un diamant cristallin est réalisée à une pression inférieure à 100 hPa et à une température supérieure à 700 °C, de préférence à 850 °C.

12. Composite de nanotubes de carbone et/ou de fibres de carbone et de diamant, ledit composite comprenant une couche barrière entre les nanotubes de carbone et/ou les fibres de carbone ou une structure se composant de nanotubes de carbone et/ou de fibres de carbone et le diamant, la couche barrière se composant d'un matériau protégeant les nanotubes de carbone et/ou les fibres de carbone contre les gaz réactifs nécessaires pour la formation d'un diamant.

13. Composite selon la revendication 12, dans lequel la couche barrière a une épaisseur inférieure à 10 nm.

14. Composite selon la revendication 12 ou 13 formant un fil de nanotubes de carbone diamanté ou une mèche discontinue de fibres de carbone diamantée.

15. Composite selon la revendication 14, formant un fil de sciage.
